Europäisches Patentamt

European Patent Office

Office européen des brevets

(11) Veröffentlichungsnummer: **0 044 021**
**B1**

(12) **EUROPÄISCHE PATENTSCHRIFT**

(45) Veröffentlichungstag der Patentschrift: **12.02.86**

(21) Anmeldenummer: **81105267.9**

(22) Anmeldetag: **07.07.81**

(51) Int. Cl.⁴: **H 01 L 23/56,** H 01 L 27/08, H 01 L 29/86

(54) **Aus MIS-Feldeffekttransistoren bestehender elektrischer Widerstand für integrierte Halbleiterschaltungen.**

(30) Priorität: **11.07.80 DE 3026361**

(43) Veröffentlichungstag der Anmeldung:
**20.01.82 Patentblatt 82/03**

(45) Bekanntmachung des Hinweises auf die Patenterteilung:
**12.02.86 Patentblatt 86/07**

(84) Benannte Vertragsstaaten:
**FR GB**

(56) Entgegenhaltungen:
**DE-A-2 930 375**
**DE-B-2 435 606**

(73) Patentinhaber: **Siemens Aktiengesellschaft Berlin und München Wittelsbacherplatz 2 D-8000 München 2 (DE)**

(72) Erfinder: **Bigall, Klaus-Dieter, Dipl.-Phys. Irisstrasse D-8011 Vaterstetten (DE)**
Erfinder: **Irmer, Heimbert, Dipl.-Ing. Wieselweg 24 D-8013 Haar (DE)**

Courier Press, Leamington Spa, England.

## 0 044 021

**Beschreibung**

Die Erfindung betrifft einen aus mindestens zwei monolithisch zusammengefaßten MIS-Feldeffekttransistoren bestehenden elektrischen Widerstand für integrierte Halbleiterschaltungen, bei dem die den Widerstand bildenden Feldeffekttransistoren gleichzeitig herstellt und bezüglich ihrer Source-Drain-Strecken hintereinander geschaltet sind und bei dem schließlich die Gates der den Widerstand bildenden Feldeffekttransistoren entweder mit der Source oder mit dem Drain des betreffenden Feldeffekttransistors verbunden sind.

In der DE—B—24 35 606 ist eine aus zwei gleichen MOS-Feldeffekttransistoren vom Verarmungstyp bestehende monolithische Schaltungskombination beschrieben, die dieser Definition genügt und bei der jeweils benachbarte Transistoren paarweise zusammengefaßt sind, indem die Gate-Elektroden der beiden Transistoren an einen gemeinsamen Schaltungspunkt zwischen dem Drain des einen Transistors und der Source des anderen Transistors gelegt sind. Aufgabe der aus der DE—AS—24 35 606 bekannten Transistorkette ist, neben einer Lösung der dort behandelten Aufgabe der Erzielung einer Vergrößerung des linearen Betriebsbreiches im Vergleich zu einem — lediglich durch einen in üblicher Weise als Lastwiderstand geschalteten MOS-Feldeffekttransistor gegebenen — Widerstand noch eine Lösung der Aufgabe zu geben, eine Unabhängigkeit des Widerstandswertes von der Stromrichtung zu erreichen.

Die in der DE—B—24 35 606 angegebene Lösung der Aufgabe, eine Unabhängigkeit des Widerstandswertes der den betreffenden Widerstand bildenden Kombination hintereinander geschalteter MOS-Feldeffekttransistoren zu erreichen, genügt erfahrungsgemäß nicht in allen Fällen. Dies ist vor allem dann der Fall, wenn der Substrateffekt auf das Verhalten der beteiligten Feldeffekttransistoren von wesentlichem Einfluß ist und der Widerstand mehr als nur zwei hintereinander geschaltete MOS-Feldeffekttransistoren zur Realisierung des für den betreffenden Fall benötigten Widerstandswertes verlangt.

Aus der DE—A—29 30 375 ist eine aus diffundierten Widerständen bestehende, an einer Referenzspannungsquelle anliegende Spannungsteilerkette bekannt, deren Teilspannungen über eine mehrstufige Transistoranordnung abgreifbar sind. Dabei ist durch Ansteuern von bestimmten Transistoren innerhalb der einzelnen Stufen das Spannungsteilerverhältnis veränderbar. Um für jeden Schaltzustand einen definierten Gesamtwiderstand, d.h. einen vom Abschlußwiderstand unabhängigen Spannungsteiler, zu erhalten, weisen die in den höheren Stufen verschalteten Transistoren ein größeres Verhältnis W/L von Kanalbreite zu Kanallänge auf als die Transistoren in den niederen Stufen. Eine Kompensation des Substrateffekts wird dabei jedoch nicht erreicht.

Hier soll nun die vorliegende Erfindung eine Abhilfe bringen.

Gemäß der Erfindung ist deshalb vorgesehen, daß die den Widerstand bildenden MIS-Feldeffekttransistoren derart gestaffelt und aufeinander abgestimmt sind, daß das Verhältnis ihrer Kanalweite zu ihrer Kanallänge den im Kennzeichen des Anspruchs 1 angegebenen Bedingungen genügt.

Die Erfindung läßt sich sowohl mit Transistoren vom Verarmungstyp als auch mit Transistoren vom Anreicherungstyp realisieren. Jedoch wird man bei der Realisierung eines Widerstandes gemäß der Erfindung zweckmäßig nur bezüglich ihres Typs übereinstimmende MIS-Feldeffekttransistoren verweden.

Damit ist erreicht, daß die durch identische Fertigungsprozesse entstandenen Feldeffekttransistoren der den Widerstand bildenden Transistorkette sich lediglich inbezug auf ihre Kanallänge L und ihre Kanalweite W von einander unterscheiden. Um aber die lateralen Abmessungen des stromführenden Kanals der einzelnen Transistoren im Sinne der Erfindung zu beeinflüssen, bedarf es deshalb keiner unterschliedlichen Fertigungsschritte sondern lediglich eine entsprechende Ausgestaltung des dem betreffenden MIS-Feldeffekttransistor jeweils zugeordneten Bereiches der bei den einzelnen Verfahrensschritten für die Gesamtschaltung jeweils benötigten Masken.

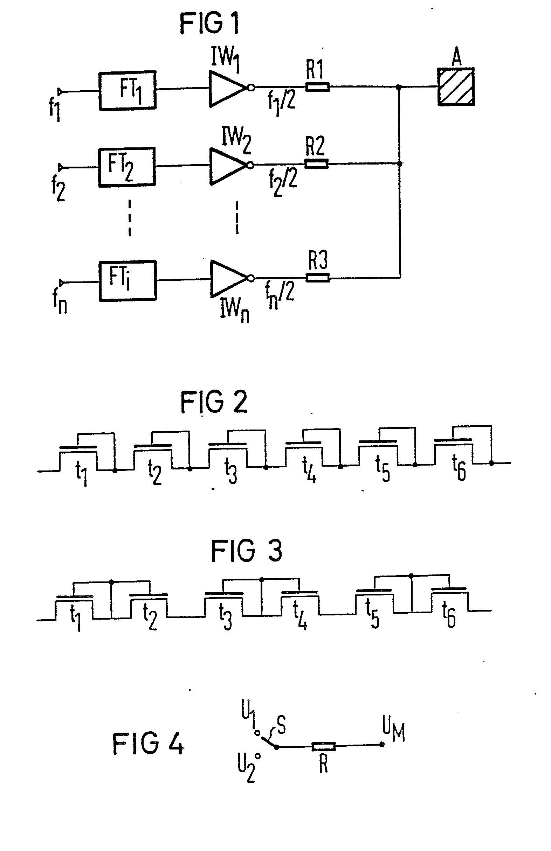

Die weitere Aufgabe der Erfindung ist es nun, die die Widerstandskette z.B. gemäß Fig. 2 oder gemäß Fig. 3 bildenden Widerstände bezüglich der Werte ihres Verhältnisses W/L derart aufeinander abzustimmen, daß die Unabhängigkeit des Widerstandswertes von der Stromrichtung auch für eine längere Transistorkette gewährleistet ist. Auf die Lösung dieser Aufgabe wird im Anschluß an die Betrachtung der Figuren 1 bis 4 eingegangen.

Vielfach benötigt man MOS-Widerstände für Analogschaltungen, bei denen eine möglichst große Unabhängigkeit des Widerstandswertes von der den Widerstand beaufschlagenden Spannung angestrebt ist. Dies gilt z.B. für die Ausgangsstufe eines monolithisch integrierten Tonfrequenzteilers, wie man ihn z.B. für elektronische Orgeln einsetzen kann. Die hierfür wesentlichen Punkte werden anhand von Fig. 1 erläutert.

Der Ausgang A des Tonfrequenzteilers wird über je einen auf je einen speziellen Wert eingestellten Entkoppelwiderstand R1 bzw. R2 bzw. R3 usw. durch je eine je eine der benötigten Tonfrequenzen darstellende elektrische Schwingung gleichzeitig beaufschlagt. Dabei sei $f_1/2$ die dem Widerstand R1 zugeteilte Frequenz, $f_2/2$ die dem Widerstand R2 zugeteilte Frequenz usw. so daß allgemein dem Widerstand Rv die Frequenz $f_v/2$ zugeordnet ist. Die Frequenzen $f_v/2$ ($v=1, 2, \ldots n$) werden jeweils von einem Frequenzteiler $FT_v$ geliefert, von denen die Frequenzteiler $FT_1$, $FT_2$ und $FT_n$ gezeichnet sind. Die Frequenzteiler $FT_v$ werden an ihren Eingängen $f_v$ gemeinsam durch einen Oszillator beaufschlagt und sind derart ausgelegt, daß sie die jeweils gewünschte Frequenz $f_v/2$ an den jeweils zugeordneten Impedanzwandler $IW_v$ abgeben, der sie dann an den jeweils zugeordneten MOS-Widerstande $R_v$ weitergibt. Die Ausgänge der vorgesehenen MOS-Widerstände $R_v$ liegen gemeinsam am Ausgang A.

2

Zur Erzielung einer intermodulationsfreien Summenspannung am Ausgang A soll durch externe Schaltungsmaßnahmen die Signalamplitude am Ausgang A klein gehalten werden. Außerdem sollen sich die als MOS-Widerstände realisierten Entkopplungswiderstände $R_v$ nicht in Abhängigkeit von der von dem jeweils zugeordneten Impedanzwandler $IW_v$ zur Verfügung gestellten H/L-Spannungen ändern. Eine Änderung des Widerstandswertes der Entkopplungswiderstände ist aber wegen des bekannten Substrateffekts prinzipiell bedingt und durch die üblichen Mittel nicht so ohne weiteres vermeidbar. Daher ist es die Aufgabe der Erfindung, den Einfluß des Substrateffekts auf den Widerstandswert eines aus MOS-Feldeffekttransistoren (oder allgemeiner MIS-Feldeffekttransistoren) bestehenden monolithisch integrierten Widerstandes zu kompensieren. Damit ist aber auch die Aufgabe gelöst, daß der Widerstandswert unabhängig von der Polung der den Widerstand beaufschlagenden Spannung wird.

Die einen Widerstand gemäß der Erfindung bildenden MOS-Transistoren können, wie aus Fig. 2 ersichtlich, derart hintereinander geschaltet sein, daß das Gate der einzelnen Widerstände $t_1, t_2, \ldots t_n$ (im Beispielsfalle sind sechs Widerstände $t_1$—$t_6$ gezeichnet) bei jedem der vorgesehenen Transistoren mit derselben stromführenden Elektrode des Transistors $t_i$ (i=Nummer des betreffenden Transistors in der Kette) verbunden ist, so daß je nach Polung der den Widerstand beaufschlagenden Spannung entweder bei allen Transistoren $t_i$ das Gate mit der Source oder bei allen Transistoren $t_i$ das Gate mit dem Drain verbunden ist. Aufgrund der oben gegebenen Definition der Erfindung sind alle Transistoren entweder als Transistoren vom Anreicherungstyp oder alle Transistoren als Transistoren vom Verarmungstyp ausgebildet.

Die den Widerstand gemäß der Erfindung bildenden MOS-Feldeffekttransistoren können aber auch in der aus Fig. 3 ersichtlichen Weise geschaltet sein.

Bei der in Fig. 3 dargestellten Ausgestaltung sind jeweils zwei aufeinanderfolgende Transistoren $t_1, t_2$ bzw. $t_3, t_4$ bzw. $t_5, t_6$ derart zusammengefaßt, daß ihre Gate-elektroden miteinander verbunden und außerdem an die miteinander verbundenen stromführenden Anschlüsse der beiden benachbarten Transistoren gelegt sind, so daß in der einen Richtung des über den Widerstand fließenden Stromes als auch in der anderen Richtung dieses Stromes jeweils die Hälfte der Anzahl der vorgesehenen Transistoren mit ihrem Source-Anschluß und die andere Hälfte mit ihrem Drain-Anschluß an das zugehörige Gate gelegt ist.

Bei einer Realisierung eines Widerstands gemäß der Erfindung gemäß Fig. 2, also einer "seriellen" Realisierung kann zweckmäßig eine fortlaufende Staffelung längs der Transistorkette bezüglich des Wertes von W/L angewedet werden. Diese Möglichkeit ist auch bei der antiseriellen Realisierung gemäß Fig. 3 gegeben. Hier kann man jedoch stattdessen lediglich die paarweise zusammengehörigen Transistoren bezüglich ihrer W/L-Werte so aufeinander abstimmen, daß bereits jedes einzelne Transistorpaar bezüglich seines Widerstandswertes unabhängig von der Stromrichtung wird.

Hat man nun einen aus einer Kette hintereinandergeschalteter MOS-Feldeffekttransistoren entsprechend Fig. 2 oder Fig. 3 aufgebauten Widerstand, so muüssen die einzelnen Transistoren bezüglich ihrer W/L-Werte derart aufeinander abgestimmt sein, daß beim Einsatz dieses Widerstandes R in einer Schaltung gemäß Fig. 4 folgende Bedingung

$$(1) \qquad U_1 - U_m = -(U_2 - U_M)$$

erfüllt ist. Dabei liegt der eine Anschluß des Widerstands R an einem Festpotential $U_M$, während der andere Anschluß über einen Schlater S abwechselnd an ein Potential $U_1$ und ein Potential $U_2$ anschaltbar ist. Das Potential $U_1$ kann z.B. durch das Potential $U_{SS}$, das Potential $U_2$ durch das Betriebspotential $U_{DD}$ der den MOS-Widerstand enthaltenden integrierten MOS-Halbleiterschaltung (oder umgekehrt) gegeben sein. Wegen (1) liegt das Festpotential $U_M$ genau in der Mitte zwischen den beiden Potentialen $U_1$ und $U_2$. Liegt nun das Potential $U_1$ am Widerstand R, so hat man den Strom $J_1 = (U_1 - U_M)/R$. Ist anderseits das Potential $U_2$ an den Widerstand R geschaltet, so hat man den Strom $J_2 = (U_M - U_2)/R$, wobei R den jeweiligen Wert des Widerstands bezeichnet. Es soll nun $J_1 = -J_2$ gelten, was nur dann der Fall sein kann, wenn der Wert des Widerstands R in beiden Fällen gleich ist.

Um nun die hierfür erforderlichen Bedingungen zu ermitteln, wird auf die in Fig. 2 dargestellte Schaltung des Widerstandes R hingewiesen.

Für den über den Drainanschluß des einzelnen Transistors $t_i$ fließenden Strom $J_D$ gelten, je nach Richtung des Stroms, zwei unterschiedliche Beziehungen, die sich als Sonderfälle aus der bekannten Relation

$$(2) \qquad J_D = \beta \cdot ((U_{GS} - U_T) \cdot U_{DS} - U_{DS}^2/2)$$

mit

$$(3) \qquad \beta = K' \frac{W}{L}$$

ergeben. In diesen beiden (für den ungesättigten Betrieb der Transistoren $t_i$) geltenden Gleichungen bedeutet $U_{GS}$ die Gate-Source-Spannung, $U_T$ die Schwellwertspannung, $U_{DS}$ die Source-Drain-Spannung, W die Kanalweite und L die Kanallänge, während K' eine bei allen Transistoren $t_i$ des integrierten

MOS-Widerstandes gleiche und in bekannter Weise von den Herstellungsbedingungen abhängige Konstante ist.

Die Schwellspannung $U_T$ hängt von der Betriebsrichtung ab, da in sie u.a. auch der Substrateffekt eingeht. Sie ist also jedem der Transistoren $t_i$ individuell zugeordnet und muß von Fall zu Fall ermittelt werden.

Aufgrund der in Fig. 4 dargestellten Schaltung für den Widerstand R hat man zwei Betriebsarten für die den Widerstand bildenden MOS-Transistoren. Bei der ersten Betriebsart ist $U_{GS}=0$, bei der zweiten Betriebsart ist $U_{GS}=U_{DS}$.

Betrachtet man nun den ersten Transistor $t_1$ der in Fig. 2 gegebenen Realisierung für den Widerstand R, so hat man aufgrund der Beziehung (2) für die erste Betriebsart

$$(4) \qquad J_D(t_1;1)=-\beta \cdot (U_{DS} \cdot U_T(t_1;1)+U_{DS}^2/2)$$

und für die zweite Betriebsart

$$(5) \qquad J_D(t_1;2)=\beta \cdot ((U_{DS}-U_T(t_1;2))U_{DS}-U_{DS}^2/2),$$

wobei $U_T(t_1;1)$ die Schwellenspannung des ersten Transistors $t_1$ in der ersten Betriebsart und $U_T(t_1;2)$ die Schwellenspannung des ersten Transistors $t_1$ bei der zweiten Betriebsart bedeutet. Aus den beiden Gleichungen (4) und (5) läßt sich $U_{DS}$ für den Fall ermitteln, daß

$$(6) \qquad -J_D(t_1;1)=J_D(t_1;2)$$

ist und die beiden Schwellenspannungen bekannt sind. Die beiden Schwellenspannungen $U_T(t_1;1)$ und $U_T(t_1;2)$ lassen sich als Funktion der Substratsteuerspannung berechnen.

In dem Buch "MOS LSI Design and Application" von Carr und Mize (Ausgabe 1972) ist auf Seite 57 für die Schwellenspannung $U_T$ die Beziehung

$$(7) \qquad U_T=\phi_{MS} \cdot (-Q_S/C_o)+2\phi_F-\sqrt{((2\varepsilon_H \cdot q \cdot N(2\phi_F+U_B)):C_o}$$

angegeben. Dabei bedeutet $\phi_{MS}$ die Austrittsarbeit, $Q_S$ die Ladungsdichte an der Grenze zwischen dem Halbleiter und der Gateisolation, $\phi_F$ das Ferminiveau, $\varepsilon_H$ das Produkt aus der relativen DK des Halbleiters mit der DK des Vakuums, q die Elementarladung, N die Dotierungskonzentration im Substrat, $U_B$ die Substratsteuerspannung zwischen Substrat und Source des betreffenden Transistors. Die Größe $C_o$ ist durch das durch die Dicke der Gateisolation geteilte Produkt aus der (relativen) DK der Gateisolation mit der DK des Vakuums gegeben.

Die Beziehung (7) läßt sich umformen in

$$(7a) \qquad U_T=U_T(0)+F \cdot \sqrt{U_B+2|\phi_F|}-\sqrt{2|\phi_F|},$$

wobei $U_T(0)$ die bei $U_B=0$ gegebene Schwellenspannung ist, deren Gleichung man aus (7) durch Einsetzen von $U_B=0$ erhält. Der Faktor F ist durch

$$(7b) \qquad F=\sqrt{2 \ q \cdot \varepsilon_H \cdot N}/C_o$$

gegeben.

Mittels der zuletzt genannten Beziehungen (7) bzw. (7a) und (7b) kann man aufgrund der an der an der Transistorkette gemäß Fig. 2 bei deren Verwendung als Widerstand R in der Schaltung gemäß Fig. 4 anliegenden Potentiale $U_1$ bzw. $U_2$ bzw. $U_M$ die Schwellenspannungen $U_T(t_1;1)$ und $U_T(t_1;2)$ für den ersten Transistor $t_1$ der Kette bestimmen und den aus der Beziehung (6) folgenden Wert $U_{DS}(t_1)$ für die Source-Drainspannung $U_{DS}$ des ersten Transistors $t_1$ berechnen.

Dieselbe Betrachtung kann man auch bei den übrigen Transistoren $t_i$ der Kette, also den Transistoren $t_2$, $t_3$ usw., durchführen. Damit erhält man für jeden Transistor $t_i$ einen Wert $U_{DS}(t_i)$ für die Source-Drainspannung, für den

$$(6) \qquad J_D(t_i;1)=-J_D(t_i;2)$$

gilt.

Nun ist noch zu berücksichtigen, daß der im Transistor $t_1$ der Kette fließende Strom $J_D(t_1)$ gleich dem Strom $J_D(t_i)$ jedes der übrigen Transistoren $t_i$ der Kette sein muß.

Unter Bezugnahme auf die erste Betriebsart hat man beim ersten Transistor $t_1$ gemäß (4)

$$J_D(t_1)=-\beta_1 \cdot (U_{DS}(t_1) \cdot U_T(t_1;1)+U_{DS}^2(t_1)/2)$$

oder abgekürzt

4

(a) $$J_D(t_1) = \beta_1 \cdot f(U_{DS}(t_1)).$$

In analoger Weise erhält man für den zweiten Transistor $t_2$ der Kette die Beziehung

(b) $$J_D(t_2) = \beta_2 \cdot f(U_{DS}(t_2)),$$

und allgemein für den i-ten Transistor $t_i$ der Kette

(c) $$J_D(t_i) = \beta_i \cdot f(U_{DS}(t_i)).$$

Nimmt man z.B. den Strom $J(t_1)$ durch den ersten Transistor $t_1$ als Bezugswert, so kann man aus den beiden Beziehungen (a) und (c) denjenigen Wert für $\beta_i$ ausrechnen, für den

(8) $$J_D(t_i) = J_D(t_1)$$

gilt. Dieser Wert ergibt sich gemäß

(9) $$\beta_i = \beta_1 \cdot f(U_{DS}(t_1)) : f(U_{DS}(t_i))$$

für $i = 2, 3, \ldots$

Anstelle der Beziehung (4) für die erste Betriebsart hätte man ersichtlich bei der Ableitung der Beziehung (9) auch die Beziehung (5) für die zweite Betriebsart verwenden können.

Aus jedem der ermittelten Werte für $\beta_i$ ($i = 1, 2, \ldots$) folgt gemäß (3) der jweils zugehörige Wert von W/L. Entsprechend der Nummerierung i der Transistoren $t_i$ in der Kette gemäß Fig. 2 sind die jeweils zugehörigen Werte $W_i/L_i$ gestaffelt, damit beim Einsatz der Transistorkette als Widerstand R in der Schaltung gemäß Fig. 4 der Strom bei der einen Stellung des Schalters S entgegengesetzt gleich dem Strom in der anderen Stellung des Schalters S wird.

Die an die beiden Enden der Kette zu legende Spannung $U_1 - U_M$ bzw. $U_M - U_2$ ergibt sich als Summe aller Spannungen $U_{SD}(t_i)$, also gemäß

(10) $$U_1 - U_M = \sum_{i=1}^{n} U_{DS}(t_i),$$

wobei n die Anzahl der vorgesehenen Transistoren $t_i$ ist.

Der vorgegebene Strom $J_D = J_D'$ bestimmt zahlenmäßig die die W-Verhältnisse.

Im Falle einer Schaltung gemäß Fig. 3 genügt es, die beiden jeweils über die Zusammenfassung ihrer Gates definierten Transistorpaare $t_1$, $t_2$ bzw. $t_3$, $t_4$ bzw. $t_5$, $t_6$ usw. bezüglich der das betreffende Paar bildenden beiden Transistoren so aufeinander abzustimmen, daß die (W/L)-Werte innerhalb der einzelnen Paare verschieden sind, während die ungeradzahlig nummerierten Transistoren $T_i$ der Kette denselben ersten Wert des Verhältnisses W/L und die geradzahlig nummerierten Transistoren $T_i$ denselben zweiten Wert für das Verhältnis W/L haben. Das Transistorpaar wird dann entsprechend den obigen Darstellungen ermittelt, wobei in den entsprechenden Stromgleichungen die Schaltung der das erste Paar $t_1$ und $t_2$ de Transistoren $t_i$ berücksichtigt werden muß. Dies geschieht unter Verwendung der Beziehungen (4) und (5). Die weiteren Transistorpaare $t_3$, $t_4$ usw. werden ebenfalls entsprechend der obigen Methode bestimmt. Falls nur mit geometrisch gleichen Transistorpaaren gearbeitet werden soll (Schaltung gemäß Fig. 3), müssen die W/L-Verhältnisse analog zu der obigen anhand von Fig. 2 betrachteten Methode — aber unter Anwendung eines Iterationsverfahrens — sukzessive berechnet werden.

Die oben beschriebene Kompensationsmethode kann nur exakt auf

1) vorgegebene Spannungen $(U_1 - U_M)$ bzw. $(U_M - U_2)$ und

2) auf einen bestimmten Substratsteuerungsfaktor F (vgl. (7b)) erfolgen. Bei Schwankungen des Substratsteuerungsfaktors ist deshalb eine exakte Kompensationsmöglichkeit nicht gegeben.

3) Wesentlich für die erfolgreiche Durchführung der Kompensationsmethode ist außerdem, daß die am Aufbau des Widerstandes R bereiligten MOS-Transistoren mit einem gemeinsamen Substratanschluß versehen sind.

Widerstände R, die aus je einer Transistorkette entsprechend Fig. 2 oder Fig. 3 bestehen, sind zum Einsatz in der in Fig. 1 dargestellten Schaltung vorzüglich geeignet, sobald die (W/L)-Verhältnisse der in der Kette aufeinander folgenden Transistoren derart gestaffelt sind, daß die Wirkung des Substrateffekts auf das Verhalten dieser Widerstände in der beschriebenen Weise kompensiert ist.

**Patentansprüche**

1. Aus mindestens zwei monolithisch zusammengefaßten MIS-Feldeffekttransistoren bestehender elektrischer Widerstand für integrierte Halbleiterschaltungen, bei dem die den Widerstand bildenden Feldeffekttransistoren gleichzeitig hergestellt und bezüglich ihrer Source-Drain-Strecken hintereinander geschaltet sind, bei dem die Gates der den Widerstand bildenden Feldeffekttransistoren entweder mit der Source oder mit dem Drain des betreffenden Feldeffekttransistors verbunden sind, und bei welchem sich die den Widerstand bildenden Feldeffekttransistoren bezüglich des Verhältnisses ihrer Kanalweite (W) zu ihrer Kanallänge (L) voneinander unterscheiden, dadurch gekennzeichnet, daß die den Widerstand (R) bildenden MIS-Feldeffekttransistoren $(t_i)$ derart gestaffelt und aufeinander abgestimmt sind, daß unter der Bedingung

$$(U_1-U_M)=-(U_2-U_M)=\frac{n}{2}U_{DS}\ (t_i)$$

das zugehörige Kanalweist/Kanallänge-Verhältnis $(W_i/L_i)$ folgendermaßen gegeben ist:

$$W_i/L_i=\frac{1}{K'}\cdot \beta_1 \cdot f(U_{DS}(t_1)):f(U_{DS}(t_i))=$$

$$\frac{1}{K'}\cdot \beta_1 \cdot (U_{DS}(t_1)\cdot U_T(t_1;U_{GS}=0)+U_{DS}^2(t_1)/2)\Big/$$

$$\Big/(U_{DS}(t_i)\cdot U_T(t_i;U_{GS}=0)+U_{DS}^2(t_i)/2),$$

wobei gilt:
$U_1$=ein erstes Potential
$U_2$=ein zweites Potential
$U_M$=ein zwischen $U_1$ und $U_2$ liegendes Festpotential
$U_{DS(t_i)}$=Drain-Source-Spannung des i-ten Transistors
$U_{T(t_i)}$=Schwellwertspannung des i-ten Transistors
$K'$=ein von den Transistorherstellungsbedingungen abhängiger Proportionalitätsfaktor

$$\beta=K'\cdot \frac{W}{L}$$

f( ... )=Funktion von ( ...).

2. Elektrischer Widerstand nach Anspruch 1, dadurch gekennzeichnet, daß die Feldeffekttransistoren paarweise durch Verbindung ihrer Gates zusammengefaßt sind, daß die W/L-Verhältnisse innerhalb der einzelnen Paare unterschiedlich sind, und daß die ungeradzahlig nummerierten Feldeffekttransistoren $t_i$ der Kette das selbe erste W/L-Verhältnis und die geradzahlig nummerierten Feldeffekttransistoren $t_i$ das selbe zweite W/L-Verhältnis aufweisen.

3. Elektrischer Widerstand nach Anspruch 1, dadurch gekennzeichnet, daß die den Widerstand (R) bildenden n MIS-Feldeffekttransistoren $(t_i)$ bezüglich der Werte $(W_i/L_i)$ des Verhältnisses (W/L) derart gestaffelt und aufeinander abgestimmt sind, daß für eine Spannung $(U_1-U_M)$ und eine zweite Spannung $(U_M-U_2)$ unter der Bedingung

$$(U_1-U_M)=-(U_2-U_M)$$

und unter der Bedingung, daß das Potential $U_M$ auf einen der beiden Anschlüsse des Widerstands (R) festgehalten ist, beim Anlegen der zweiten Spannung betragsmäßig derselbe Strom aber mit entgegengesetzter Richtung durch den Widerstand (R) fließt, wie er beim Anlegen der ersten Spannung $(U_1-U_M)$ in entgegengesetzter Richtung gegeben ist.

4. Elektrischer Widerstand nach Anspruch 2, dadurch gekennzeichnet, daß die den Widerstand (R) bildenden 2n Feldeffekttransistoren $(t_i)$ derart paarweise zusammengefaßt sind, daß die Gateanschlüsse der beiden Transistoren am Source-Anschluß des einen Transistors und am Drainanschluß des anderen Transistors liegen und daß die beiden das betreffende Paar bildenden Transistoren nur bezüglich des Verhältnisses ihrer Kanalweite (W) zu ihrer Kanallänge (L) voneinander verschieden sind.

5. Elektrischer Widerstand nach Anspruch 4, dadurch gekennzeichnet, daß die beiden Transistoren in jedem der n Transistorpaare des Widerstandes (R) bezüglich des Verhältnisses (W/L) derart aufeinander abgestimmt sind, daß bei einem bestimmten Wert der an dem betreffenden Paar liegenden Spannung der Widerstandswert des betreffenden Transistorpaares unabhängig von der Polung dieser Spannung wird.

6. Elektrischer Widerstand nach Anspruch 4 oder 5, dadurch gekennzeichnet, daß jeder der den Widerstand (R) bildenden Feldeffekttransistoren bezüglich des (W/L)-Verhätlnisses von jedem anderen dieser Feldeffekttransistoren verschieden ist.

7. Elektrischer Widerstand nach Anspruch 6, dadurch gekennzeichnet, daß die den Widerstand bildenden 2n Feldeffekttransistoren bezüglich der Werte des Verhältnisses (W/L) derart gestaffelt sind, daß für eine an die Anschlüsse des Widerstands (R) gelegte erste Spannung $(U_1-U_M)$ als auch für eine dieser entgegengesetzt gleiche Spannung $(U_2-U_M)$ betragsmäßig derselbe Strom durch den Widerstand fließt.

8. Elektrischer Widerstand nach einem der Ansprüche 1 bis 7, dadurch gekennzeichnet, daß die den Widerstand bildenden MIS-Feldeffekttransistoren entweder alle vom Anreicherungstyp oder alle vom Verarmungstyp sind.

**Revendications**

1. Résistance électrique constituée d'au moins deux transistors à effet de champ MIS réunis monolithiquement pour circuits à semi-conducteurs intégrés, dont les transistors à effet de champ constituant la résistance sont fabriqués simultanément et sont montés en série par leurs circuits source-drain, dont les grilles des transistors à effet de champ constituant la résistance sont connectées, soit à la source, soit au drain du transistor à effet de champ concerné et dont les transistors à effet de champ constituant la résistance de distinguent l'un de l'autre en ce qui concerne le rapport de leur largeur de canal (W) sur leur longueur de canal (L), caractérisée en ce que les transistors à effet de champ MIS $(t_i)$ constituant la résistance (R) sont échelonnés et accordés les uns aux autres de manière que, si la condition

$$(U_1-U_M)=-(U_2-U_M)=\frac{n}{2}U_{DS}(t_i)$$

est satisfaite, on obtienne le rapport largeur de canal/longueur de canal $(W_i/L_i)$ correspondant suivant:

$$W_i/L_i=\frac{1}{K'}\cdot\beta_1\cdot f(U_{DS}(t_1)):f(U_{DS}(t_i))=$$

$$\frac{1}{K'}\cdot\beta_1\cdot(U_{DS}(t_1)\cdot U_T(t_1;U_{GS}=0)+U_{DS}^2(t_1)/2)\Big/$$

$$\Big/(U_{DS}(t_i)\cdot U_T(t_i;U_{GS}=0)+U_{DS}^2(t_i)/2),$$

où

$U_1=$un premier potentiel
$U_2=$un second potentiel
$U_M=$un potentiel fixe compris entre $U_1$ et $U_2$
$U_{DS(t_i)}=$tension drain-source du i-ème transistor
$U_{T(t_i)}=$tension de seul de i-ème transistor
$K'=$un facteur de proportionnalité dépendant des conditions de fabrication du transistor

$$\beta=K'\cdot\frac{W}{L}$$

$f(\ldots)=$fonction de $(\ldots)$.

2. Résistance électrique selon la revendication 1, caractérisée en ce que les transistors à effet de champ sont réunis par paires par la connexion de leurs grilles, que les rapports W/L à l'intérieur des différentes paires sont différents et que les transistors à effet de champ $t_i$ de numéro impair de la chaîne présentent un premier rapport W/L égal et les transistors à effet de champ $t_i$ de numéro pair présentent un deuxième rapport W/L égal.

3. Résistance électrique selon la revendication 1, caractérisée en ce que les n transistors à effet de champ MIS $(t_i)$ constituant la résistance (R) sont échelonnés et mutuellement accordés, pour ce qui concerne les valeurs $(W_i/L_i)$ du rapport (W/L), de manière que, pour une tension $(U_1-U_M)$ et une deuxième tension $(U_M-U_2)$ présentant la relation

$$(U_1-U_M)=-(U_2-U_M)$$

et sous la condition que le potentiel $U_M$ sur l'une des deux bornes de la résistance (R) soit maintenu fixe, la résistance (R) à l'application de la deuxième tension, soit parcourue par le même courant en valeur numérique, mais de sens contraire que lors de l'application de la première tension $(U_1-U_M)$ dans le sens opposé.

4. Résistance électrique selon la revendication 2, caractérisée en ce que les 2 n transistors à effet de champ $(t_i)$ constituant la résistance (R) sont réunis par paires de manière que les bornes de grille des deux transistors soient connectées à la borne de source de l'un et à la borne de drain de l'autre transistor et que les deux transistors formant la paire concernée diffèrent seulement l'un de l'autre du point de vue du rapport de leur largeur de canal (W) sur leur longueur de canal (L).

5. Résistance électrique selon la revendication 4, caractérisée en ce que les deux transistors dans chacune des n paires de transistors de la résistance (R) sont mutuellement accordés, en ce qui concerne la rapport (W/L), de manière que, pour une valeur déterminée de la tension appliquée à la paire concernée, la valeur de résistance de cette paire de transistors devienne indépendante de la polarité de cette tension.

6. Résistance électrique selon la revendication 4 ou 5, caractérisée en ce que chacun des transistors à effet de champ constituant la résistance (R) diffère de chacun des autres transistors à effet de champ pour ce qui concerne le rapport (W/L).

7. Résistance électrique selon la revendication 6, caractérisée en ce que les 2 n transistors à effet de champ constituant la résistance sont échelonnés, pour ce qui concerne les valeurs du rapport (W/L), de manière que, pour une première tension $(U_1-U_M)$ appliquée aux bornes de la résistance (R) comme pour une tension $(U_2-U_M)$ égale mais de sens opposé, la résistance soit parcourue par le même courant en valeur numérique.

8. Résistance électrique selon une des revendications 1 à 7, caractérisée en ce que les transistors à effet de champ MIS constituant la résistance sont tous, soit du type à enrichissement soit du type à déplétion.

**Claims**

1. An electrical impedance for integrated semiconductor circuits which consists of at least two monolithically combined MIS field effect transistors, wherein the field effect transistors which form the impedance are simultaneously produced with series connected source-drain paths, wherein the gates of the field effect transistors which form the impedance are either connected to the source or to the drain of the the respective field effect transistor, and wherein the field effect transistors which form the impedance differ from one another in respect of the ratio of their channel width (W) to their channel length (L), characterised in that the field effect transistors $(t_i)$ forming the impedance (R) are staggered and matched to one another in such a manner that provided that

$$(U_1-U_M)=-(U_2-U_M)=\frac{n}{2}U_{DS}(t_i)$$

the assigned channel width/channel length ratio $(W_i/L_i)$ is given as follows:

$$W_i/L_i=\frac{1}{K'}\cdot \beta_1 \cdot f(U_{DS}(t_1)):f(U_{DS}(t_i))=$$

$$\frac{1}{K'}\cdot \beta_1 \cdot (U_{DS}(t_1) \cdot U_T(t_1;U_{GS}=0)+U_{DS}^2(t_1)/2)\Big|$$

$$\Big|(U_{DS}(t_i) \cdot U_T(t_i;U_{GS}=0)+U_{DS}^2(t_i)/2),$$

where:—

$U_1$=a first potential;

$U_2$=a second potential;

$U_M$=a fixed potential arranged between $U_1$ and $U_2$;

$U_{DS(t_i)}$=drain source voltage of the i-th transistor;

$U_{T(t_i)}$=threshold voltage of the i-th transistor;

$K'$=a proportionality factor dependent upon the manufacturing conditions of the transistor;

$$\beta=K' \cdot \frac{W}{L}; \text{ and}$$

$f(\ldots)$=a function of $(\ldots)$.

2. An electrical impedance as claimed in Claim 1, characterised in that the field effect transistors are combined in pairs by connecting their gates, that the W/L-ratios within the individual pairs are variable, and that the field effect transistors $t_i$ of the chain which are odd-numbered have the same first W/L-ratio and the even-numbered field effect transistors $t_i$ have the same second W/L-ratio.

3. An electrical impedance as claimed in Claim 1, characterised in that the MIS field effect transistors $(t_i)$ which form the impedance (R) are staggered in respect of the values $(W_i/L_i)$ of the ratio (W/L) and matched to one another in such a manner that for a voltage $(U_1-U_M)$ and a second voltage $(U_M-U_2)$ provided that

**0 044 021**

$$(U_1 - U_M) = -(U_2 - U_M)$$

and provided that the potential $U_M$ is connected to one of the two terminals of the impedance (R), during the connection of the second voltage the same current in terms of value but with opposite direction flows through the impedance (R) as given during the connection of the first voltage $(U_1 - U_M)$ in opposite direction.

4. An electrical impedance as claimed in Claim 2, characterised in that the 2n field effect transistors $(t_i)$ which form the impedance (R) are combined in pairs in such a manner that the gate terminals of the two transistors are connected to the source terminal of the one transistor and to the drain terminal of the other transistor and that the two transistors which form the respective pair are only different from one another in respect of the ratio of their channel width (W) to their channel length (L).

5. An electrical impedance as claimed in Claim 4, characterised in that the two transistors are matched to one another in each of the n transistor pairs of the impedance (R) in respect of the ratio (W/L) in such a manner that at a specific value of the voltage which is connected to the respective pair, the impedance value of the respective transistor pair becomes independent of the polarity of this voltage.

6. An electrical impedance as claimed in Claim 4 or 5, characterised in that each of the field effect transistors which forms the impedance (R) differs in respect of the (W/L)-ratio from each of the other field effect transistors.

7. An electrical impedance as claimed in Claim 6, characterised in that the 2n field effect transistors which form the impedance are staggered in respect of the values of the ratio (W/L) in such a manner that for a first voltage $(U_1 - U_M)$ connected to the terminals of the impedance (R) and for a voltage $(U_2 - U_M)$ which is inversely identical to the former, a current of the same value flows through the impedance.

8. An electrical impedance as claimed in one of Claims 1 to 7, characterised in that the MIS field effect transistors forming the impedance are either all of the enrichment type or all of the depletion type.

FIG 1

FIG 2

FIG 3

FIG 4

1